Europäisches Patentamt

European Patent Office

Office européen des brevets

(11) Publication number: **0 266 869**
**A1**

# EUROPEAN PATENT APPLICATION

(21) Application number: 87307625.1

(22) Date of filing: 28.08.87

(51) Int. Cl.⁴: **H05K 9/00**

(30) Priority: 30.08.86 GB 8621026

(43) Date of publication of application:
**11.05.88 Bulletin 88/19**

(84) Designated Contracting States:
**BE DE FR NL**

(71) Applicant: **THE MARCONI COMPANY LIMITED**
**The Grove Warren Lane**
**Stanmore Middlesex HA7 4LY(GB)**

(72) Inventor: **Henderson, William Iain Mackie**
**91 Edge Hill Darras Hall**
**Ponteland Northumberland NE20 9JQ(GB)**
Inventor: **Morrison, David John**
**5 Hobart Whitley Bay**
**Tyne & Wear NE26 3TA(GB)**
Inventor: **Smith, Moira**
**19 Foxhills Covert**
**Wickam Newcastle NE16 5TN(GB)**
Inventor: **Thornley, David John**
**4 Sunny Brae Ryton**
**Tyne & Wear NE40 4JB(GB)**
Inventor: **Leask, Samuel Hall**
**27 Walworth Avenue**
**Narsden Estate South Shields NE34 7EP(GB)**
Inventor: **Matthews, Christopher F.**
**Dere Hollow**
**Riding Hill Northumberland NE44 5DQ(GB)**

(74) Representative: **Tolfree, Roger Keith**
**GEC p.l.c. Central Patent Department**
**Chelmsford Office Marconi Research Centre**
**West Hanningfield Road**
**Great Baddow Chelmsford Essex CM2**
**8HN(GB)**

(54) A container designed to provide shielding against electromagnetic radiation.

(57) A container designed to provide shielding against electromagnetic radiation comprises electromagnetic sealing strips (7) which cover joints between panels (3) of the container. Each strip (7) has lips (9) which face the panels and is secured to the panels by rivets (8) which deform the strip (7) and cause the lips (9) to be pressed by the resilience of the strip against the panels (3) thus forming an electromagnetic seal.

FIG. I.

1a.

# A Container Designed to Provide Shielding against Electromagnetic Radiation

This invention relates to a container designed to provide shielding against electromagnetic radiation.

There is a demand for such containers for use as shelters for transportable electric equipment.

The invention arose in the design of a transportable shelter for electronic equipment formed from conductive wall, floor and roof panels joined together at their edges. It was found that in some circumstances electromagnetic interference could leak between adjoining edges of the panels and the invention aims to meet this problem.

According to the invention there is provided a container designed to provide shielding against electromagnetic interference, the container comprising panels having electrically conductive inner surfaces; and an electrically conductive sealing strip covering a join between the panels, the strip having lips which face the panels and the strip being secured to the panels by means which resiliently deforms the strip so as to cause the lips to be pressed by the resilience of the strip against the panels thereby forming a seal against leakage of electromagnetic interference.

The panels do not need to be electrically conductive throughout their thickness. It is sufficient that they have a conductive surface facing the interior of the container. In a preferred construction they are made from a laminar structure having an inner layer of rigid foamed plastics material bonded to outer sheets of metal, one of which faces the interior of the container, the other forming a weather resistant surface on the outside.

The aforementioned lips preferably have sharp edges which dig into the conductive inner surfaces of the panels. This feature has been found significantly to improve the quality of the electromagnetic seal. It is desirable that the strip should be made of a harder material than the conductive surface to facilitate penetration of the sharp edges into the latter. The strip can for example be made of steel and the conductive surface of aluminium or an aluminium alloy. It would however also be practicable to use an aluminium or alloy strip.

The strip is preferably secured to the panels by rivets since in applying the rivets the strip can at the same time be deformed in the manner required to press the lips against the conductive surface. Rivets of a type which can be applied from one side only are preferred where a laminar structure as previously described is used for the panels.

It would be possible to employ a sealing strip which is substantially flat, with its edges projecting towards one side to form the lips. A strip like this may be used to form a seal between coplanar panels joined edge to edge. Preferably, however, the strip bridges a corner joint between panels and has a uniform angular cross-section defined by two arms having outwardly projecting lips.

The strip may be extruded, or formed from bent sheet material.

One way in which the invention may be performed will now be described, by way of example with reference to the accompanying drawings in which:

Figure 1 shows a vertical cross-section through a portion of a radar shelter, the top and side panels of which are joined together, and are bridged by a sealing strip which is a feature of the invention; and

Figure 2 shows a cross-section of the sealing strip of figure 1 before it is secured to the panels.

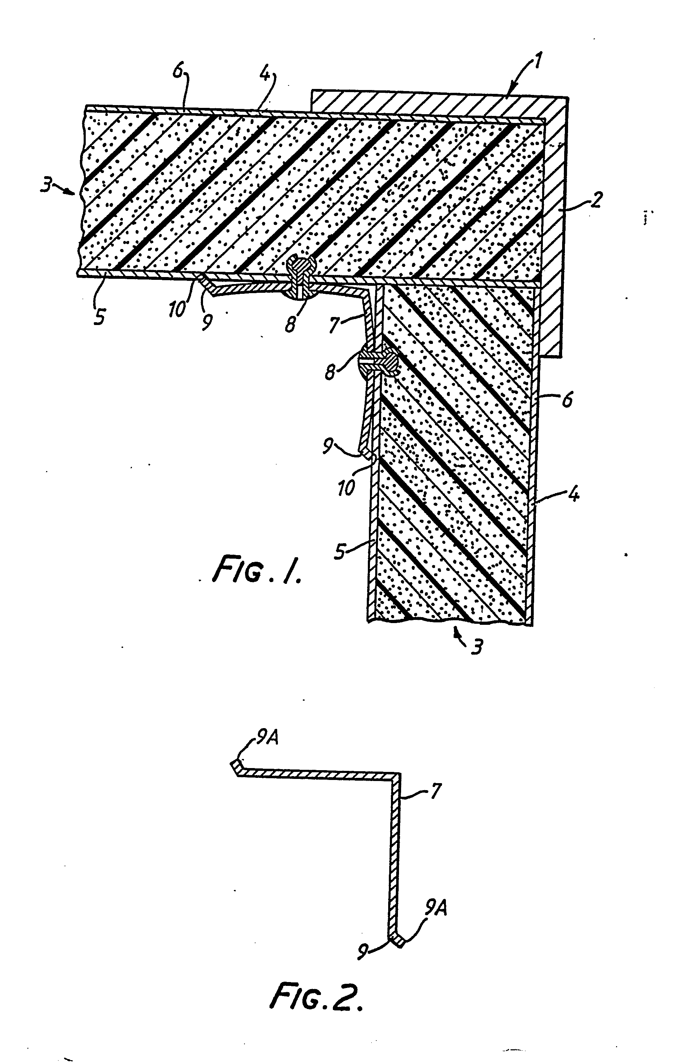

Referring to figure 1, a corner joint denoted generally by the reference numeral 1, of a radar shelter is formed from a supporting frame member 2, which may be made of a metal such as aluminium and two panels 3. Each panel 3, is formed from a layer 4 made from a rigid foamed plastics material. Each of the layers 4, carries a conductive layer 5 which is exposed on the interior of the shelter and an outer conductive layer 6 exposed on the outside. A sealing strip 7 is secured to the panels 3 by rivets 8. The rivets 8 are of a type which can be applied from one side of the workpiece only and penetrate only the conductive surface 5 and the sealing strip 7.

The strip 7 has, before it is filled, an angular cross-section as shown in figure 2, with ends which project outwardly to form lips 9 having sharp edges 9A.

When the strip 7 is secured to the panels 3 by the rivets 8, it is resiliently deformed by the force applied by the rivets, and the lips 8 are caused to dig into the inner conductive layers 5 thus forming indentations 10 and consequently an excellent seal against radio frequency interference.

## Claims

1. A container designed to provide shielding against electromagnetic interference, the container comprising panels (3) having electrically conductive inner surfaces (5); and an electrically conductive sealing strip (7) covering a join between the panels, characterised in that the strip (7) has lips (9) which face the panels and in that the strip (7) is secured to the panels (3) by means (8) which resiliently deforms the strip (7) so as to cause the lips (9) to be pressed by the resilience of the strip against the panels (3) thereby forming a seal against leakage of electromagnetic interference.

2. A container according to claim 1 characterised in that the lips (9) have sharp edges (9A) which dig into the panels (3).

3. A container according to claim 1 or 2 characterised in that panels (3) are formed by rigid foamed plastics material (4) carrying a conductive layer (5) on inside surfaces thereof and in which the sealing strip (7) is secured to the panels by rivets (8) passing through the said conductive layer (5) and the strip (7).

4. A container according to claim 3 characterised in that each panel (3) has an outer conductive layer (4), which layer is not penetrated by the rivets.

5. A container according to any preceding claim characterised in that the strip (7) bridges a corner joint between panels (3) and has a uniform cross-section having an angular shape defined by two arms the ends of which project outwardly to form the lips (9).

FIG. 1.

FIG.2.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-2 978 531 (L.H. APPLEMAN)<br>* column 5, lines 66-75; figure 8 *<br>--- | 1,5 | H 05 K 9/00 |
| A | DE-A-2 300 576 (LITTON INDUSTRIES)<br>* page 8, line 34 - page 9, line 11; figure 8 *<br>--- | 2 | |
| A | US-A-3 147 336 (H.G. MATHEWS)<br>* column 1, lines 32-37; column 2, lines 23-28; figures 2, 3 *<br>--- | 3,4 | |
| A | US-A-3 783 174 (E.A. LINDGREN)<br>* column 4, line 65 - column 5, line 6; figures 4-5 *<br>--- | 3,4 | |
| A | US-A-2 924 638 (F. FEKETICS)<br>* figure 7 *<br>----- | 1 | |

TECHNICAL FIELDS SEARCHED (Int. Cl.4)

H 05 K 9/00

The present search report has been drawn up for all claims

| Place of search | Date of completion of the search | Examiner |
|---|---|---|
| BERLIN | 16-11-1987 | LEOUFFRE M. |